(19) Europäisches Patentamt
European Patent Office
Office européen des brevets

(11) **EP 3 907 307 A1**

(12) **EUROPEAN PATENT APPLICATION**

(43) Date of publication:
**10.11.2021 Bulletin 2021/45**

(51) Int Cl.:
***C23C 16/30*** *(2006.01)*   ***C23C 16/34*** *(2006.01)*
***C23C 16/56*** *(2006.01)*   ***C30B 25/00*** *(2006.01)*
***C30B 33/02*** *(2006.01)*

(21) Application number: **20173722.8**

(22) Date of filing: **08.05.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Universität Zürich**
  **8001 Zürich (CH)**
• **Hong Kong University of Science and Technology**
  **Hong Kong (HK)**

(72) Inventors:
• **CUN, Huanyao**
  **8046 Zürich (CH)**

• **HEMMI, Adrain**
  **70745 Churwalden (CH)**
• **MIAO, Zichun**
  **Henan Province (CN)**
• **ALTMAN, Michael Scott**
  **Hong Kong SAR (HK)**
• **OSTERWALDER, Jürg**
  **8320 Fehraltorf (CH)**
• **GREBER, Thomas**
  **8003 Zürich (CH)**

(74) Representative: **Kleine, Hubertus et al**
  **Loesenbeck - Specht - Dantz**
  **Patent- und Rechtsanwälte**
  **Am Zwinger 2**
  **33602 Bielefeld (DE)**

(54) **A METHOD FOR ON-SURFACE SYNTHESIS OF A HEXAGONAL BORON NITRIDE MONOLAYER**

(57)    A method for the formation of a layer of boron nitride, especially a hexagonal boron nitride monolayer, on a substrate (300) wherein the method is **characterized by** the following steps:
A Providing a layer of boron nitride, especially a hexagonal boron nitride monolayer (200), on a first substrate (100);
B Delamination of the boron nitride layer (200) from the first substrate (100) and transfer of said layer (200) to a second substrate (300);
C Annealing the layer (200) on said second substrate (300) by heating to a first target temperature under formation of a first crystal structure, preferably in vacuum;
D Annealing the layer (200) on said second substrate (300) by heating to a second target temperature under formation of second crystal structure, wherein the second target temperature is higher than the first target temperature; and a first BN-Layer and a second BN-Layer.

Fig. 1

**Description**

**Technical Field**

The subject of the present invention is a method for on-surface synthesis of a hexagonal boron nitride monolayer and a monolayer hexagonal boron nitride, herein mentioned as *d-BN,* with enhanced quality, especially to a chemical vapor deposition (CVD) applied on a surface boron-nitride layer, preferably formed by said method.

The potential of the current invention is to achieve a controlled production of a two-dimensional (2D) BN-monolayer (*d-BN*) for 2D electronics, spintronics, optoelectronics and plasmonic elements, ultimately thin membranes and for surface protection, i.e., against oxidation/corrosion.

Preferably said layer can be applied on arbitrary surfaces of various materials and is not limited to materials that are suitable support materials under production conditions, for example CVD conditions, or the like.

**Background Art**

The term "two-dimensional material", as described in the current invention, has been defined by Geim A.K., Grigorieva I.V. in "Van der Waals heterostructures", Nature, 2013, 499, 419-425.

The development of these 2D materials is expected to enable unprecedented opportunities for new devices with ultimately thin membranes, mechanical detectors, inks and specifically it will open unique opportunities for developing electronic elements beyond the silicon technology.

Before realizing the benefits of such opportunities, the fabrication, characterization and handling of 2D materials have to be mastered. This is a challenge since these materials consist of surfaces, which are known to be most prone to imperfections like contaminations and other defects.

It is therefore an object of the invention to have a package material that is protective, tight, thin, flat, transparent, and non-reactive.

Hexagonal boron nitride (*h*-BN) has all these properties and is a prime candidate to become the key 2D package material. There are, however, no scalable methods for the production a BN monolayer with quality that is sufficient for applications that can rival mechanical exfoliation from small state-of-the-art synthetic single crystals, which is capable of producing BN with outstanding quality but only in trace amounts. Currently the main approach for scalable production of thin *h*-BN is chemical vapor deposition (CVD) of precursors that contain boron and nitrogen like borazine $(HBNH)_3$ and segregation-assisted growth combined with CVD that were reported previously.

After production, for most applications the material has to be exfoliated and transferred from the growth substrate to a new surface on which the device shall be built. This transfer is another challenge, since it is, if successful, often accompanied with compromise of the material quality.

*The following documents are related to the* above-described *state-of-the-art:*

Surwade, S. P.; Smirnov, S. N.; Vlassiouk, I. V.; Unocic, R. R.; Veith, G. M.; Dai, S.; Mahurin, S. M. Water desalination using nanoporous single-layer graphene. Nat. Nanotechnol. 2015, 10, 459-464.

Cartamil-Bueno, S. J.; Cavalieri, M.; Wang, R.; Houri, S.; Hofmann, S.; van der Zant, H. S. J. Mechanical characterization and cleaning of CVD single-layer h-BN resonators. NPJ 2D Mater. Appl. 2017, 1, 1-7.

Torrisi, F.; Hasan, T.; Wu, W.; Sun, Z; Lombardo, A.; Kulmala, T. S.; Hsieh, G.-W.; Jung, S.; Bonaccorso, F.; Paul, P. J.; Chu, D.; Ferrari, A. C. Inkjet-printed graphene electronics. ACS Nano 2012, 6, 2992-3006.

Novoselov, K. S.; Geim, A. K.; Morozov, S. V.; Jiang, D.; Zhang, Y.; Dubonos, S. V.; Grigorieva, I. V.; Firsov, A. A. Electric field effect in atomically thin carbon films. Science 2004, 306, 666-669.

Banszerus, L.; Schmitz, M.; Engels, S.; Dauber, J.; Oellers, M.; Haupt, F.; Watanabe, K. ; Taniguchi, T.; Beschoten, B.; Stampfer, C. Ultrahigh-mobility graphene devices from chemical vapor deposition on reusable copper. Sci. Adv. 2015, 1, e1500222.

Cao, Y.; Fatemi, V.; Fang, S.; Watanabe, K. ; Taniguchi, T.; Kaxiras, E.; Jarillo- Herrero, P. Unconventional superconductivity in magic-angle graphene superlattices. Nature 2018, 556, 43-50.

Cao, V., Yuan and Fatemi; Demir, A.; Fang, S.; Tomarken, S. L.; Luo, J. Y.; Sanchez- Yamagishi, J. D.; Watanabe, K.; Taniguchi, T.; Kaxiras, E.; Ashoori, R. C.; Jarillo-Herrero, P. Correlated insulator behaviour at half-filling in magic-angle graphene super-lattices. Nature 2018, 556, 80-84.

Dean, C. R.; Young, A. F.; Meric, I.; Lee, C.; Wang, L.; Sorgenfrei, S.; Watanabe, K. ; Taniguchi, T.; Kim, P.; Shepard, K. L.; Hone, J. Boron nitride substrates for high-quality graphene electronics. Nat. Nanotechnol. 2010, 5, 722-726.

Watanabe, K.; Taniguchi, T.; Kanda, H. Direct-bandgap properties and evidence for ultraviolet lasing of hexagonal boron nitride single crystal. Nat. Mater. 2004, 3, 404-409.

Nagashima, A.; Tejima, N.; Gamou, Y.; Kawai, T.; Oshima, C. Electronic structure of monolayer hexagonal boron nitride physisorbed on metal surfaces. Phys. Rev. Lett. 1995, 75, 3918-3921.

Auwärter, W.; Kreutz, T.; Greber, T.; Osterwalder, J. XPD and STM investigation of hexagonal boron nitride on Ni(111). Surf. Sci. 1999, 429, 229-236.

Corso, M.; Auwärter, W.; Muntwiler, M.; Tamai, A.; Greber, T.; Osterwalder, J. Boron nitride nanomesh. Science 2004, 303, 217-220.

Suzuki, S.; Pallares, R. M.; Hibino, H. Growth of atomically thin hexagonal boron nitride films by diffusion through a metal film and precipitation. J. Phys. D: Appl. Phys. 2012, 45, 385304.

Zhang, C.; Fu, L.; Zhao, S.; Zhou, Y.; Peng, H.; Liu, Z. Controllable Co-segregation synthesis of wafer-scale hexagonal boron nitride thin films. Adv. Mater. 2014, 26, 1776-1781.

Cun, H. Y.; Hemmi, A.; Miniussi, E.; Bernard, C.; Probst, B.; Liu, K.; Alexander, D. T. L.; Kleibert, A.; Mette, G.; Weinl, M.; Schreck, M.; Osterwalder, J.; Radenovic, A.; Greber, T. Centimeter-sized single-orientation monolayer hexagonal boron nitride with or without nanovoids. Nano Lett. 2018, 18, 1205-1212.

Goriachko, A.; He,; Knapp, M.; Over, H.; Corso, M.; Brugger, T.; Berner, S.; Osterwalder, J.; Greber, T. Self-Assembly of a hexagonal boron nitride nanomesh on Ru(0001). Langmuir 2007, 23, 2928-2931.

Morscher, M.; Osterwalder, J.; Greber, T. Formation of single layer h-BN on Pd(111). Surf. Sci. 2006, 600, 3280-3284.

Cun, H. Y.; Iannuzzi, M.; Hemmi, A.; Roth, S.; Osterwalder, J.; Greber, T. Immobilizing individual atoms beneath a corrugated single layer of boron nitride. Nano Lett. 2013, 13, 2098-2103.

**Object of the invention**

With regard to the cited state-of-the-art, one object of the current invention is to provide a method for the application of a two-dimensional hexagonal BN monolayer formed on a first substrate to a second substrate material, wherein said hexagonal BN monolayer positioned on said second substrate has excellent quality.

The BN monolayer having enhanced quality especially in terms of alignment to the second substrate is formed after its application on said second surface. This formation is herein called a "on-surface synthesis" of a hexagonal boron nitride monolayer.

It is a further object of the current invention to provide a new two-dimensional h-BN monolayer by scalable method and/or with quality superior to that obtained by conventional CVD.

It can be a further object of the current invention to provide a method with relatively mild process condition for the formation of a BN-layer, especially a hexagonal BN-monolayer with enhanced quality.

A BN-layer produced by said inventive method can be applied to a second substrate which is not exposed to a precursor environment and without complex application devices such as a glove box, full setup of gas input and exhaust lines for precursors etc.

**Disclosure of the invention**

The current invention overcomes the aforementioned objections resulting from said state-of-the-art with the subject-matter of claim 1.

An inventive method for the formation of a layer of boron nitride, especially a boron-nitride monolayer, on a substrate comprises at least the following steps:

A    Providing a layer of boron nitride, especially a boron nitride monolayer, herein called *h-BN,* on a first substrate;

B    Delamination of the boron nitride layer from the first substrate and transfer of said layer to a second substrate, termed "back-transfer", wherein the delaminated layer is herein called *t-BN;*

C    Annealing the layer on said second substrate by heating to a first target temperature under formation of a first crystal structure, herein called *m-BN;*

D    Annealing the layer on said second substrate by heating to a second target temperature under formation of second crystal structure, herein called *d-BN*

wherein the second target temperature is higher than the first target temperature. Step C and D might be performed under vacuum.

The order of steps, especially Steps C and D provide a hexagonal BN monolayer, *d-BN,* that can be applied to various substrates. The limitation of the layer remaining on the first substrate does not exist anymore.

Therefore, a mass production of suitable layers for various second substrates, preferably in a way of a selective coating, can be achieved in a cost-effective way.

The method especially allows the back-transfer of hexagonal BN covered with Polymethylmethacrylat (PMMA) or similar polymer films sample to catalytic substrates.

It can be formed at and/or transferred to various substrates such as Rh(111) Pt(111), ruthenium surfaces and/or silicon dioxide surfaces.

The size of *d*-BN is scalable up to wafer size. There is no need for an ultra-high vacuum system. A normal vacuum system is sufficient.

There are also no precursors and no precursor setup needed. The quality of a d-BN monolayer can be enhanced with the annealing treatment.

The method is a simple and low-cost way for the production of 2D hexagonal BN monolayers without any need for control of vapor pressure and the like.

Further advantageous embodiments of the invention are subject-matter of the dependent claims.

The boron-nitride nitride layer in step A can preferably be applied on the first substrate by chemical vapor deposition.

The delamination in step B can be done by electrochemical delamination. This technique is known from the cited state-of-the-art publications. Details for the delamination process can be derived from the documents mentioned above.

The first substrate in step A and B can preferably be a catalytic substrate with a rhodium surface and/or with another transition metal surface and/or with an insulator-surface like that of $SiO_2$, wherein the layer of boron nitride is applied to said surface. The substrate might consist of said materials or a base material is coated with said materials by a formation of the aforementioned surfaces.

A catalytic substrate is a substrate which enables the growth, especially the CVD growth, of 2D-layers, especially boron nitride, at low temperatures and pressures compared to the homoepitaxial growth. This catalytic substrate also allows functionalisations of the layer of boron nitride which is of advantage.

A catalytic substrate may also enable a selective growth and orientation of the boron nitride layer.

Further suitable substrates as a first substrate are Rh(111), Rh(110), Ir(111), Ni(111), Ni(110), Ni(100), Cu(111), Cu(110), Ag(111), Ag (100), Au(111), Pt(111), Pd(111), Pd(110), Cr(110), Mo(110), Fe(110), Ru(0001), Re(0001), Co(0001), Sapphire (0001), Graphite (0001).

The second substrate in step B-D is an arbitrary substrate, preferably a catalytic surface is suitable for the use as second substrate. This way the layer can be removed from said second surface after annealing. There is however also the option that the BN-layer remains on said second substrate after the annealing procedure at step D for the aforementioned method. Most preferred are a rhodium surface and/or a ruthenium surface. A $SiO_2$-surface is also suitable but less preferred. Said surfaces are the surfaces where the layer of boron nitride is applied as *t*-BN-layer after delamination from the first substrate.

The first target temperature is between 500-900 K, preferably 600-800 K. The second target temperature is higher than 950 K, preferably between 980-1450 K.

The first crystal structure in step C may consist of a moire superstructure pattern formed by the crystal lattice of the second substrate in step B and the hexagonal BN lattice, due to the difference in their lattice constants. The hexagonal BN deposition in step B allows complete rotational degree of freedom between these two crystal lattices and accordingly the final moire lattice constant can be tuned within the geometrical limitation of moire patterns.

The crystal structure in step C has preferably a superlattice constant which is smaller than that of the layer of boron nitride provided in step A.

The second crystal structure in step D can preferably be an aligned two-dimensional boron nitride layer. The moire superstructure lattice constant depends on the lattice constant of the second substrate. It is about 3.2 nm for Rh being the second substrate or 3.5 nm for Ru(0001) being the second substrate.

The transfer can be done outside of a CVD-system and most preferably at temperatures below 350 K, more preferably below 320 K.

In a preferred embodiment the method comprises a further step E, wherein the layer at said second substrate is separated from said second substrate such that a stand-alone layer with the properties of the crystal structure in step D for the application on any substrate is provided.

It was surprisingly found that after the first annealing step at the second substrate the binding forces of the layer to said second substrate are less strong than towards the first substrate after step A but the quality, especially the crystal quality of the BN monolayer was enhanced compared to the *h*-BN layer and also to the *t*-BN and m-BN layer. Therefore, a delamination to receive a stand-alone 2D hexagonal BN layer, in the context of the current invention also called monolayer, is achieved without the deformation or destruction of the crystal structure.

A further element of the current invention is a first boron nitride layer, which is the aforementioned *d*-BN layer, consisting of 2D-layer of boron nitride molecules, preferably without an adherence to a substrate after delamination from said second substrate.

Before said delamination of said BN-Layer, *d*-BN, from said second substrate, one can measure the lattice constant of the *d*-BN layer on the second substrate, and one can determine the superlattice constant, derived from said values.

When said BN-layer is applied on a rhodium surface said BN-layer has a variance $\sigma^2$ of the mosaicity is less than 0.22 deg$^2$, preferably less than 0.12 deg$^2$, most preferably between 0.04 and 0.10 deg$^2$.

The standard deviation of the BN lattice constant (strainfluctuation) is less than 0.0030 Å, preferably less than 0.0025 Å most preferably between 0.0025 Å and 0.0022 Å.

A further element of the current invention is a second boron nitride layer applied to a substrate having a moire structure (*m*-BN).

Said boron nitride layers can be produced by said inventive method.

Said boron structure, especially the *d*-BN structure, can be used as a membrane. They can also be used as protection layer against oxidation/corrosion, or such BN layer as capsuling material to make sandwich structures with 2D materials. Another application would be the use of said BN-structure as a tunneling barrier.

**Brief Description of the drawings (Figures and Tables)**

Some advantageous embodiments for inventive process and a BN-Layer are further explained in detail below together with drawings. Specific parts of the different embodiments can be understood as separate features that can also be realized in other embodiments of the invention. The combination of features described by the embodiment shall not be understood as a limitation for the invention:

Fig. 1        a schematic view of the steps of an embodiment of the current invention;

Fig. 2A       a schematic view of a scanning tunneling microscopy (STM) image (U=-1.20 V, I=0.05 nA) of a *h*-BN structure after step A of the method at room temperature including some voids;

Fig. 2B       a schematic view of a STM image (U=-1.20 V, I=0.05 nA) of a m-BN structure after back-transfer on rhodium substrate and annealing to 750 K in step C of the method (STM made at room temperature);

Fig. 2C       a schematic view of a STM image (U=-1.20 V, I=0.05 nA) of a *d*-BN structure after back-transfer and annealing to 1000 K in step D of the method (STM made at room temperature);

Fig. 3A-3F    LEED images, BN lattice rotations and lattice parameters from scanning $\mu$-LEED at room temperature. Fig 3A *h*-BN layer grown on Rh(111) and annealed to 1210 K. Fig. 3B *t*-BN delaminated from Rh(111) first substrate Fig. 3C *m*-BN after annealing to 1100 K. Fig. 3D *d*-BN distilled from *m*-BN up to 1210 K Fig. 3E Histogram of the rotation angles of more than 1250 measurements on each material. The average *m*-BN rotation angle of 24.3° is subtracted. Fig. 3F Histogram of the lattice constants of more than 1250 measurements on each material;

LEEM can also be performed as bright field image (E=12 eV) after annealing.

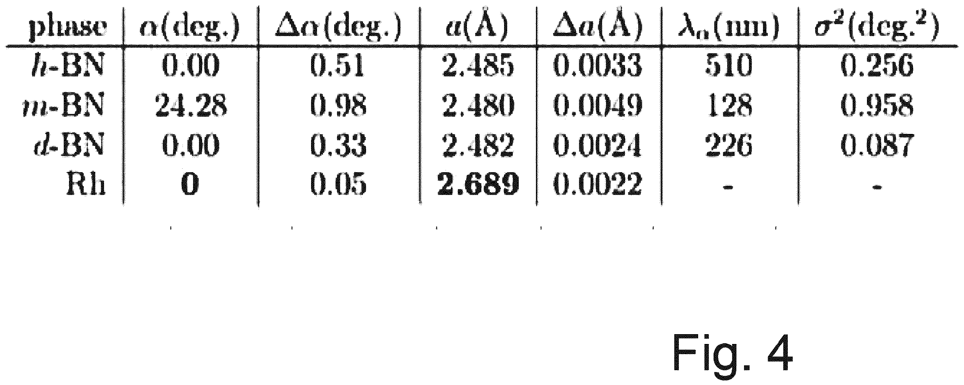

Fig. 4 / Table 1 A table of crystallographic data obtained for crystal structures of BN layers at different steps of the method.

**Mode for Carrying out the invention**

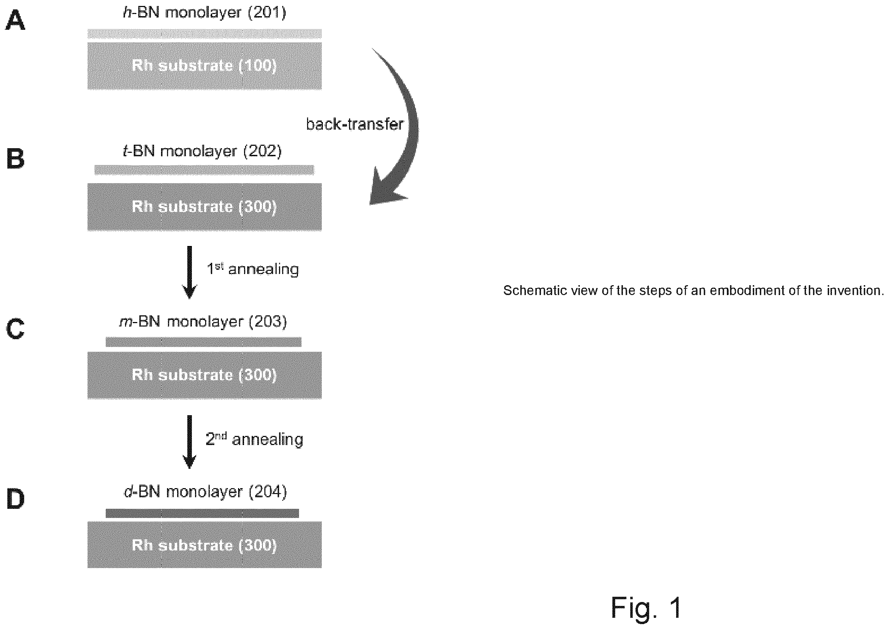

Basic steps of the inventive method are shown in **Fig. 1A**. It comprises a formation of a monolayer of boron nitride (200), preferably in a CVD-formation process. It comprises further a transfer of CVD-grown single layer of boron nitride from a first substrate onto a second substrate, which can preferably be a catalytic substrate. And it comprises a heating step to a first and a second target temperature within an annealing process.

The proximity of the second substrate during the transfer, especially when it has the function as a catalytic substrate, helps to clean the material and the 2D-sublimation temperature of B and N from the edge of *m*-BN is lowered, such that a heat treatment of the transferred BN-layer leads to formation of high-quality hexagonal boron nitride are observed.

Preferably *h*-BN (201) monolayers can be fabricated this way. Said BN-layers can be produced on wafers of single crystalline Rh(111) films. Said wafers are in the current example 4 inches.

The structure of monolayer *h*-BN on Rh(111) is formed in a CVD process as the first step 1 as shown in Fig. 1, where the Rh(111) substrate (100) acts as a catalyst for the decomposition of the borazine precursor molecules (HBNH)$_3$ at high temperature.

Suitable CVD methods are disclosed by Nagashima et al., Auwärter et al. and Corso et al., mentioned in the statement cited above. This growth procedure is self-limited by the fact that a single layer *h*-BN (201) suppresses the catalytic activity of said substrate. The *h*-BN forms a so-called "nanomesh", which can be described as a super-honeycomb-structure with 13 × 13 *h*-BN units aligned onto 12 × 12 Rh unit cells. The bonding of the *h*-BN is mediated by nitrogen lone pairs with directly on top of Rh atoms and long-range van der Waals interactions. This yields to lateral stress between substrate and adsorbate and to a pronounced geometric and electronic corrugation at the nanometer scale.

Alternatively, or additionally to rhodium, ruthenium can be used according to the invention as a suitable material for the first substrate (100). Also other substrate materials are suitable, however with the aforementioned substrate materials the interactions between substrate and adsorbate are strong, while for example for Pd(111) no pronounced azimuthal lock-in was observed.

Therefore, CVD does not allow the growth of single orientation *h*-BN on all substrates, while transfer of single orientation *h*-BN on these substrates is possible.

After CVD growth, a *h*-BN monolayer can be functionalized and transferred in a second step 2 on to arbitrary substrates, which are labeled in Fig. 1 as transferred BN (*t*-BN) (202). The transfer, herein also referred to as "back-transfer", of *h*-BN was performed onto the Rh (111) as a second substrate (300), which are in this example, the same surfaces as the *h*-BN was grown on. However, the lattice of *t*-BN and the Rh substrates normally are not aligned, as it is the case for the *h*-BN (201).

The back-transfer is performed with an electrochemical delamination procedure. More details for the specific steps of the back-transfer procedure has been described by Cun et al. and Hemmi et al. in the state-of-the-art mentioned above.

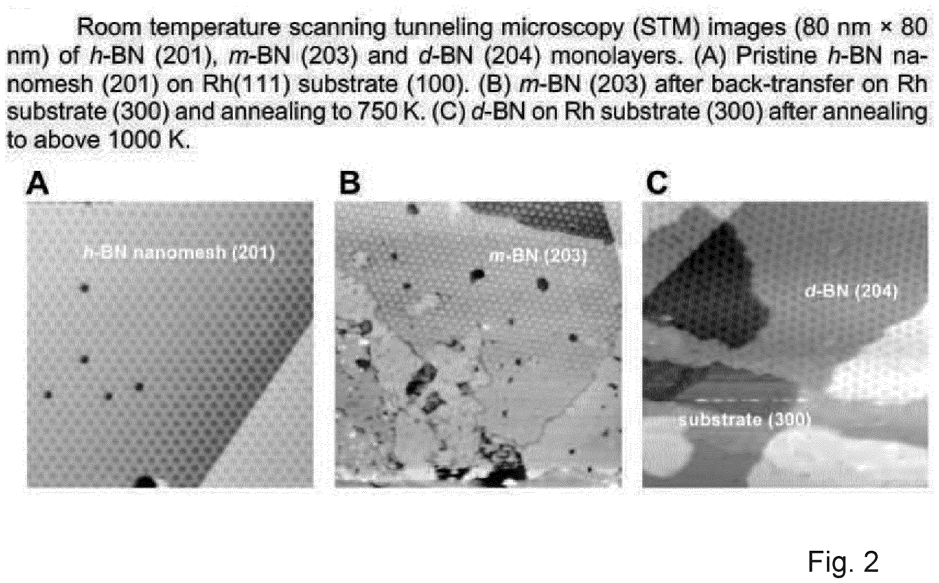

In a third step 3 the structure and moires structures (*m*-BN) (203) are cleaned. The catalytic Rh-surface helps by annealing to 750 K as first target temperature. The moire structure can be resolved with scanning tunneling microscopy (STM), shown in the Figure 2B. These structures do not reach the thermodynamic equilibrium at this temperature.

At said higher temperature *m*-BN (203) transforms into *d*-BN (204), i.e., nanomesh reforms. The *d*-BN (204) is formed on Rh(111. The annealing temperature as second target temperature at this fourth step 4 is above 1000 K. STM image in Figure 2C shows the lattice structure of *d*-BN (204). The STM scanning parameters are U = -1.20 V, I = 0.50 nA.

Annealing to higher temperatures leads to 2D-sublimation of *m*-BN (203) on the Rh surface (300), where said fourth step leads to formation of aligned 2D boron nitride (*d*-BN) or in other words to a crystalline material consisting of a single layer of atoms.

**Figure 2A** shows a STM image of a CVD-grown *h*-BN monolayer on Rh(111). Some voids have been observed These voids are not part of the inventive BN-layer or the method but can be used as a proof for the reformation of the layer at the different steps of the method. The voids are therefore considered as a fingerprint of an unaltered BN layer after transfer.

**Figure 2B** displays a representative STM image of a *h*-BN monolayer with such voids that was back-transferred on said Rh(111) substrate.

A hexagonal super-lattice is discerned. Compared to the material in Figure 2A, the moire lattice constant is 25% smaller, and the unit cell displays a 0.1 nm protrusion and not a depression in the center. Applying the geometric theory of a periodic overlayer moire pattern for a rotated and isotropically scaled overlayer, the moire super lattice constant of 2.4 nm indicates that this back-transferred *h*-BN flake was rotated by 4°. With respect to the Rh lattice and constitutes *m*-BN.

After annealing and formation of *d*-BN, the formation of a superstructure with a lattice constant of 3.2 nm has been observed, which is within the error bar of the *h*-BN nanomesh.

Furthermore, the voids as seen in Fig. 2A and 2B disappeared in the *d*-BN structure of **Fig. 2C**. Fig. 2A-2C have the same nanometer range. This indicates that above 1000 K *m*-BN starts to transform back into the thermodynamically more stable hexagonal BN (*d*-BN).

For the study of macro- and mesoscopic properties of back-transferred BN at the millimeter scale, other characterization methods than STM have to be employed. While low energy electron diffraction (LEED) maps the macroscopic crystallinity, ultraviolet photoelectron spectroscopy (UPS) provides details on the electronic structure.

The advantages of the inventive method as described above are that the catalytic metal substrate helps to clean the BN monolayer with a chemical processing at lowest temperatures possible.

The formation of a two-dimensional material into a new 2D material layer is a new fabrication process. So far formation of BN from the gas phase (CVD) or by segregation out of the bulk substrate or by mechanical exfoliation has been known.

A direct observation and control of all pre-described process steps is possible. This way the alignment angle between BN and the second substrate, especially between the *m*-BN and substrate, can directly be influenced.

The pre-described layers are further characterized by different measurements. Low energy electron microscopy (LEEM) images with energy E=12eV after annealing to 1100K and LEEM images with E=15eV after annealing to 1210K can be recorded. The $\mu$-LEED patterns can be recorded from said images for example within a 250 nm spot within said LEEM image.

As reference for the determination of absolute lattice constants, the Rh substrate lattice constant of 3,8031Å that translate into nearest neighbor distance of 2,689 Å has been used. By scanning $\mu$-LEED lattice parameters of different phases during the formation of the inventive BN-layer can be quantified as well as the lattice rotation angle $\underline{\alpha}$ between the Rh substrate and the BN layer, and the lattice constant **a.** The data can be recorded in an area of $5 \times 5$ $\mu$m with 1250 up to 2500 pixels.

From the histograms of $\underline{\alpha}$ and **a,** the average and the standard deviations of such as mosaic spreads may be inferred directly. In order to further characterize the quality of the layers an autocorrelation analysis of the mosaic angles could be performed. The autocorrelation determines how related the signals in two pixels at distance

$$\rho - \rho_0 = \sqrt{\Delta x^2 + \Delta y^2}$$

$$(1)$$

are. For the pixel maps with signals $\underline{\alpha}$ (x, y) the following spatial autocorrelation can be used

$$R_{\alpha,\alpha}(\rho - \rho_0) = \frac{1}{N} \sum_{i=1}^{N} \alpha_i(\rho)\alpha_i(\rho_0)$$

$$(2)$$

where N is the number of pixels in the image and whenever "$\rho$-$\rho_0$" falls outside the set of pixels "$\alpha_i(\rho)\alpha(\rho_0)$" is set zero. If the average of a dataset is zero, "$R_{\alpha,\alpha}(0)$" is the variance $\sigma^2$. For white noise "$R_{\alpha,\alpha}(0)$" drops to zero for $(\rho$-$\rho_0)>0$ because there is no correlation between different pixels. If there is a correlation between neighboring pixels that decays exponentially, the following equation can be deduced:

$$R_{\alpha,\alpha}(\rho - \rho_0) = \sigma^2 \exp(-(\rho - \rho_0)/\lambda_\alpha)$$

$$(3)$$

where the decay length $\lambda_\alpha$ is a characteristic length-scale that is extracted from the dataset of the angular orientation and where for the case of *m*-BN the average rotation angle $\alpha$ has been subtracted.

The table 1 shows the structural parameters extracted from the $\mu$-LEED data from the $\mu$-LEED-scan and from properties of the Rh-substrate.

The variance $\sigma^2$ as obtained from the autocorrelation of equation (2) for $\rho$-$\rho_0$=0 and confirms the assignment $\Delta\alpha=\sigma$.

The lattice orientation $\alpha$ of Rh and the lattice constant a of Rh are reported in the literature for example in Zemann et al, cited in the state-of-the-art of this document.

The rotational mosaic $\Delta\alpha$ and the lattice constant variation $\Delta a$ are the standard deviations of the observed distributions for the given phases. $\Lambda_\alpha$ is the lateral correlation length of the lattice orientation. $\Sigma^2$ is the autocorrelation $R_{\alpha,\alpha}$ (0), i.e., variance of data sets.

Voids and pores can be formed in the *h*-BN layer during the provision of the *h*-BN monolayer at the beginning of the aforementioned process. These voids disappear at least during the second annealing step and thus can be used as a control or quality indicator for the formation of a *d*-BN monolayer.

In the Table one can also find the correlation length as a number that can qualify the materials.

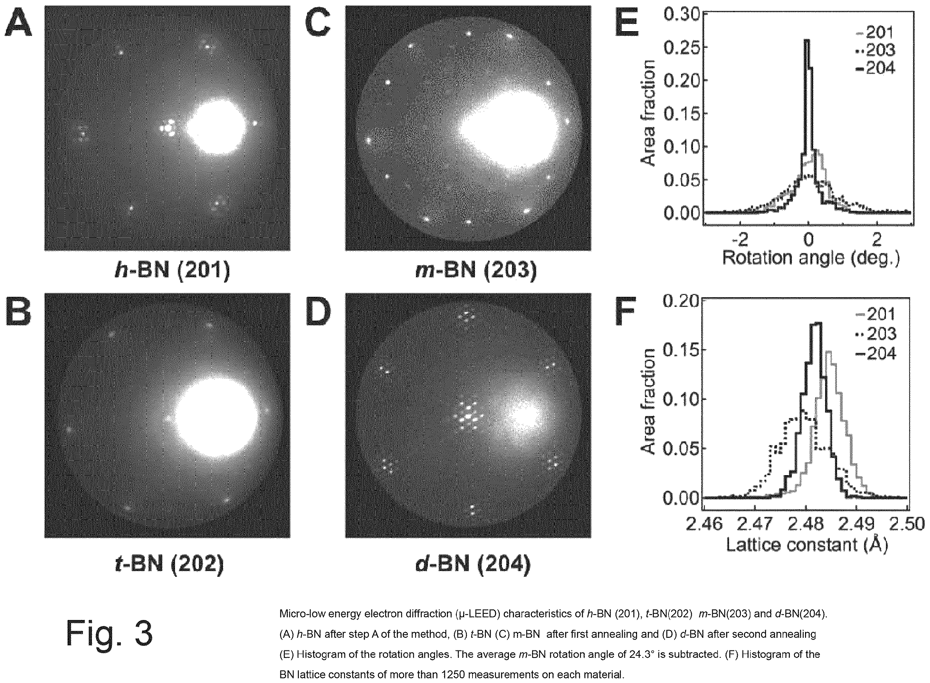

When said BN-layer is applied on a rhodium surface said BN-layer has a variance $\sigma^2$ is less than 0.22 deg$^2$, preferably less than 0.12 deg$^2$, most preferably between 0.04 and 0.10 deg$^2$. Said variance can be derived from Fig. 3E and Fig. 3F. In Fig. 3E there is a measurement for the determination of a standard deviation of the rotation angle, which is considerably sharper for *d*-BN (204) than that for *h*-BN (201) and *m*-BN (203). This effect can be expressed by the

aforementioned variance $\sigma^2$.

The standard deviation of the BN lattice at a Rh-substrate is constant with than 0.0030 Å, preferably less than 0.0025 Å, most preferably between 0.0025 Å and 0.0022 Å. Fig. 3F also show a graph for the lattice constant. Both - the variance and the standard deviation may describe the enhanced quality of the $d$-BN layer formed after step D on said second substrate.

The enhanced quality of the $d$-BN layer can also be derived from Fig. 3A-3D. In these graphs one can see radial spots and a central spot. From these spots a lattice constant can be derived. If there is a high variation from spot to spot the lattice is braced, which is undesired. As one can see the spots are in Fig. 3D can be derived with a better resolution compared to $h$-BN, $t$-BN and $m$-BN, which is a sign for a excellent alignment of the BN-lattice vector to the lattice vector of the substrate, being parallel to each other.

It is also remarkable for the formed $d$-BN layer that this layer can be provided by relatively low temperature and without $H_2$-atmosphere which is important for the formation of a highly crystalline layer.

**List of references**

| | |
|---|---|
| 1 | first step |
| 2 | second step |
| 3 | third step |
| 4 | fourth step |

| | |
|---|---|
| 100 | first substrate |

| | |
|---|---|
| 200 | BN-layer |

| | |
|---|---|
| 201 | $h$-BN monolayer |
| 202 | $t$-BN monolayer |
| 203 | $m$-BN monolayer |
| 204 | $d$-BN monolayer |

| | |
|---|---|
| 300 | second substrate |

**Claims**

1. A method for the formation of a layer of boron nitride, especially a hexagonal boron nitride monolayer, on a substrate (300) wherein the method is **characterized by** the following steps:

   A Providing a layer of boron nitride, especially a hexagonal boron nitride monolayer (200), on a first substrate (100);
   B Delamination of the boron nitride layer (200) from the first substrate (100) and transfer of said layer (200) to a second substrate (300);
   C Annealing the layer (200) on said second substrate (300) by heating to a first target temperature under formation of a first crystal structure, preferably in vacuum;
   D Annealing the layer (200) on said second substrate (300) by heating to a second target temperature under formation of second crystal structure,

   wherein the second target temperature is higher than the first target temperature.

2. The method according to claim 1, **characterized in that** the boron nitride layer (200) provided in step A is applied on the first substrate (100) by chemical vapor deposition.

3. The method according to one of the preceding claims **characterized in that** the delamination in step B is done by an electrochemical delamination.

4. The method according to one of the preceding claims **characterized in that** the first substrate (100) in step A and B is a catalytic substrate, preferably with a rhodium surface and/or with a ruthenium surface and/or with a SiO$_2$-sur-

face, wherein the layer of boron nitride is applied to said catalytic surface.

5. The method according to one of the preceding claims **characterized in that** the second substrate (300) in step B-D is an arbitrary substrate, preferably a rhodium surface and/or with a ruthenium surface and/or with a $SiO_2$-surface, wherein the layer of boron nitride is applied to said surface.

6. The method according to one of the preceding claims **characterized in that** the first target temperature is between 500-900 K, preferably 600-800 K and/or wherein the second target temperature is higher than 1000 K.

7. The method according to one of the preceding claims **characterized in that** the first crystal structure in step C on said second structure (300) is a moire BN-monolayer.

8. The method according to one of the preceding claims **characterized in that** the crystal structure in step C has a superlattice constant which is smaller than that of the layer of boron nitride (200) provided in step A, preferably at least 15% smaller.

9. The method according to one of the preceding claims **characterized in that** the second crystal structure in step D is an aligned two-dimensional boron nitride layer, and its superlattice, in the case that the substrate is a Rh surface, is preferably at 3.20 (+/-0.2) nm, in the case that the substrate is a ruthenium surface, most preferably 3.50 (+/-0.2) nm.

10. The method according to one of the preceding claims **characterized in that** the transfer is done outside of a CVD-system and most preferably at temperatures below 350 K, more preferably below 320 K.

11. The method according to one of the preceding claims **characterized in that** the method comprises a further step E, wherein the layer at said second substrate is separated from said second substrate such that a stand-alone layer with the properties of the crystal structure in step D for the application on any substrate is provided.

12. A boron nitride layer (204) consisting of 2D-layer of boron nitride, **characterized in that** the boron nitride layer, when applied on a substrate with a rhodium surface, preferably on a rhodium thin-film layer of a substrate, has a variance $\sigma^2$ of the mosaicity is less than 0.22 $deg^2$, preferably less than 0.12 $deg^2$, most preferably between 0.04 and 0.10 $deg^2$.

13. A boron nitride layer (204) consisting of 2D-layer of boron nitride, preferably a boron nitride layer (204) according to one of the preceding claims **characterized in that** the boron nitride layer, when applied on a substrate with a rhodium surface, preferably on a rhodium thin-film layer of a substrate, has a standard deviation of the BN lattice constant with less than 0.0030 Å, preferably less than 0.0025 Å, most preferably between 0.0025 Å and 0.0022 Å.

14. A boron nitride layer (203) **characterized in that** the BN-layer (203) when applied to a substrate, has the form of a moire structure.

15. A boron nitride layer according to claim 14, **characterized in that** the rotation angle $\alpha$ is tunable on a substrate (300).

16. A boron nitride layer (203, 204) according to claim 12-15, **characterized in that** the layer is produced by a method according to one of the preceding claims.

17. Use of a boron nitride layer (203, 204) as a membrane, especially as protection layer against oxidation/corrosion, or such BN layer as capsuling material to make sandwich structures with other 2D materials.

A    *h*-BN monolayer (201)

Rh substrate (100)

back-transfer

B    *t*-BN monolayer (202)

Rh substrate (300)

1st annealing

Schematic view of the steps of an embodiment of the invention.

C    *m*-BN monolayer (203)

Rh substrate (300)

2nd annealing

D    *d*-BN monolayer (204)

Rh substrate (300)

Fig. 1

Room temperature scanning tunneling microscopy (STM) images (80 nm × 80 nm) of *h*-BN (201), *m*-BN (203) and *d*-BN (204) monolayers. (A) Pristine *h*-BN nanomesh (201) on Rh(111) substrate (100). (B) *m*-BN (203) after back-transfer on Rh substrate (300) and annealing to 750 K. (C) *d*-BN on Rh substrate (300) after annealing to above 1000 K.

Fig. 2

EP 3 907 307 A1

**Fig. 3**

Micro-low energy electron diffraction (μ-LEED) characteristics of *h*-BN (201), *t*-BN(202) *m*-BN(203) and *d*-BN(204).

(A) *h*-BN after step A of the method, (B) *t*-BN (C) m-BN after first annealing and (D) *d*-BN after second annealing

(E) Histogram of the rotation angles. The average *m*-BN rotation angle of 24.3° is subtracted. (F) Histogram of the BN lattice constants of more than 1250 measurements on each material.

| phase | $\alpha$(deg.) | $\Delta\alpha$(deg.) | $a$(Å) | $\Delta a$(Å) | $\lambda_0$(nm) | $\sigma^2$(deg.$^2$) |
|---|---|---|---|---|---|---|
| $h$-BN | 0.00 | 0.51 | 2.485 | 0.0033 | 510 | 0.256 |
| $m$-BN | 24.28 | 0.98 | 2.480 | 0.0049 | 128 | 0.958 |
| $d$-BN | 0.00 | 0.33 | 2.482 | 0.0024 | 226 | 0.087 |
| Rh | **0** | 0.05 | **2.689** | 0.0022 | - | - |

Fig. 4

EP 3 907 307 A1

Europäisches
Patentamt

European
Patent Office

Office européen
des brevets

**EUROPEAN SEARCH REPORT**

Application Number

EP 20 17 3722

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RUIZHI WANG ET AL: "A peeling approach for integrated manufacturing of large mono-layer h-BN crystals", ARXIV.ORG, CORNELL UNIVERSITY LIBRARY, 201 OLIN LIBRARY CORNELL UNIVERSITY ITHACA, NY 14853, 30 July 2018 (2018-07-30), - 30 July 2018 (2018-07-30), XP081252364, | 1-11 | INV. C23C16/30 C23C16/34 C23C16/56 C30B25/00 C30B33/02 |
| Y | * two last lines; page 4 * * two firts lines and middle paragraph; page 5; figure 1 * * second paragraph; page 9; figure 3 * * last paragraph; page 10 * ----- | 12-17 | |
| Y | CORSO M ET AL: "Boron Nitride Nanomesh", SCIENCE, vol. 303, no. 5655, 9 January 2004 (2004-01-09), pages 217-220, XP002800440, AMERICAN ASSOC. ADV. SCI. USA ISSN: 0036-8075, DOI: 10.1126/science.1091979 | 12-17 | |
| A | * the whole document * ----- | 1-11 | TECHNICAL FIELDS SEARCHED (IPC) C23C C30B |
| A | WO 2011/127258 A1 (MASSACHUSETTS INST TECHNOLOGY [US]; SHI YUMENG [US] ET AL.) 13 October 2011 (2011-10-13) * the whole document * ----- -/-- | 1-17 | |

The present search report has been drawn up for all claims

| Place of search | Date of completion of the search | Examiner |
|---|---|---|
| The Hague | 23 September 2020 | Martinez Miró, M |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 20 17 3722

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | MORSCHER M ET AL: "Formation of single layer h-BN on Pd(111)", SURFACE SCIENCE, NORTH-HOLLAND, AMSTERDAM, NL, vol. 600, no. 16, 15 August 2006 (2006-08-15), pages 3280-3284, XP025000098, ISSN: 0039-6028, DOI: 10.1016/J.SUSC.2006.06.016 [retrieved on 2006-08-15] * the whole document * | 1-17 | |
| A | NAPPINI SILVIA ET AL: "Chemical composition and interaction strength of two-dimensional boron-nitrogen-carbon heterostructures driven by polycrystalline metallic surfaces", APPLIED SURFACE SCIENCE, vol. 479, 11 February 2019 (2019-02-11), - 11 February 2019 (2019-02-11), pages 903-913, XP085663980, ISSN: 0169-4332, DOI: 10.1016/J.APSUSC.2019.01.274 * the whole document * | 1-17 | |

TECHNICAL FIELDS
SEARCHED (IPC)

The present search report has been drawn up for all claims

| Place of search | Date of completion of the search | Examiner |
|---|---|---|
| The Hague | 23 September 2020 | Martinez Miró, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 17 3722

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2020

| Patent document cited in search report | Publication date | Patent family member(s) | Publication date |
|---|---|---|---|
| WO 2011127258 A1 | 13-10-2011 | US 2011256386 A1<br>WO 2011127258 A1 | 20-10-2011<br>13-10-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **GEIM A.K. ; GRIGORIEVA I.V.** Van der Waals heterostructures. *Nature,* 2013, vol. 499, 419-425
- **SURWADE, S. P. ; SMIRNOV, S. N. ; VLASSIOUK, I. V. ; UNOCIC, R. R. ; VEITH, G. M. ; DAI, S. ; MAHURIN, S. M.** Water desalination using nanoporous single-layer graphene. *Nat. Nanotechnol.,* 2015, vol. 10, 459-464
- **CARTAMIL-BUENO, S. J. ; CAVALIERI, M. ; WANG, R. ; HOURI, S. ; HOFMANN, S. ; VAN DER ZANT, H. S.** J. Mechanical characterization and cleaning of CVD single-layer h-BN resonators. *NPJ 2D Mater. Appl.,* 2017, vol. 1, 1-7
- **TORRISI, F. ; HASAN, T. ; WU, W. ; SUN, Z ; LOMBARDO, A. ; KULMALA, T. S. ; HSIEH, G.-W. ; JUNG, S. ; BONACCORSO, F. ; PAUL, P. J.** Inkjet-printed graphene electronics. *ACS Nano,* 2012, vol. 6, 2992-3006
- **NOVOSELOV, K. S. ; GEIM, A. K. ; MOROZOV, S. V. ; JIANG, D. ; ZHANG, Y. ; DUBONOS, S. V. ; GRIGORIEVA, I. V. ; FIRSOV, A. A.** Electric field effect in atomically thin carbon films. *Science,* 2004, vol. 306, 666-669
- **BANSZERUS, L. ; SCHMITZ, M. ; ENGELS, S. ; DAUBER, J. ; OELLERS, M. ; HAUPT, F. ; WATANABE, K. ; TANIGUCHI, T. ; BESCHOTEN, B. ; STAMPFER, C.** Ultrahigh-mobility graphene devices from chemical vapor deposition on reusable copper. *Sci. Adv.,* 2015, vol. 1, e1500222
- **CAO, Y. ; FATEMI, V. ; FANG, S. ; WATANABE, K. ; TANIGUCHI, T. ; KAXIRAS, E. ; JARILLO-HERRERO, P.** Unconventional superconductivity in magic-angle graphene superlattices. *Nature,* 2018, vol. 556, 43-50
- **CAO, V., YUAN ; FATEMI; DEMIR, A. ; FANG, S. ; TOMARKEN, S. L. ; LUO, J. Y. ; SANCHEZ-YAMAGISHI, J. D. ; WATANABE, K. ; TANIGUCHI, T. ; KAXIRAS, E. ; ASHOORI, R. C.** Correlated insulator behaviour at half-filling in magic-angle graphene super-lattices. *Nature,* 2018, vol. 556, 80-84
- **DEAN, C. R. ; YOUNG, A. F. ; MERIC, I. ; LEE, C. ; WANG, L. ; SORGENFREI, S. ; WATANABE, K. ; TANIGUCHI, T. ; KIM, P. ; SHEPARD, K. L.** Boron nitride substrates for high-quality graphene electronics. *Nat. Nanotechnol.,* 2010, vol. 5, 722-726

- **WATANABE, K. ; TANIGUCHI, T. ; KANDA, H.** Direct-bandgap properties and evidence for ultraviolet lasing of hexagonal boron nitride single crystal. *Nat. Mater.,* 2004, vol. 3, 404-409
- **NAGASHIMA, A. ; TEJIMA, N. ; GAMOU, Y. ; KAWAI, T. ; OSHIMA, C.** Electronic structure of monolayer hexagonal boron nitride physisorbed on metal surfaces. *Phys. Rev. Lett.,* 1995, vol. 75, 3918-3921
- **AUWÄRTER, W. ; KREUTZ, T. ; GREBER, T. ; OSTERWALDER, J.** XPD and STM investigation of hexagonal boron nitride on Ni(111). *Surf. Sci.,* 1999, vol. 429, 229-236
- **CORSO, M. ; AUWÄRTER, W. ; MUNTWILER, M. ; TAMAI, A. ; GREBER, T. ; OSTERWALDER, J.** Boron nitride nanomesh. *Science,* 2004, vol. 303, 217-220
- **SUZUKI, S. ; PALLARES, R. M. ; HIBINO, H.** Growth of atomically thin hexagonal boron nitride films by diffusion through a metal film and precipitation. *J. Phys. D: Appl. Phys.,* 2012, vol. 45, 385304
- **ZHANG, C. ; FU, L. ; ZHAO, S. ; ZHOU, Y. ; PENG, H. ; LIU, Z.** Controllable Co-segregation synthesis of wafer-scale hexagonal boron nitride thin films. *Adv. Mater.,* 2014, vol. 26, 1776-1781
- **CUN, H. Y. ; HEMMI, A. ; MINIUSSI, E. ; BERNARD, C. ; PROBST, B. ; LIU, K. ; ALEXANDER, D. T. L. ; KLEIBERT, A. ; METTE, G. ; WEINL, M.** Centimeter-sized single-orientation monolayer hexagonal boron nitride with or without nanovoids. *Nano Lett.,* 2018, vol. 18, 1205-1212
- **GORIACHKO, A.; HE ; KNAPP, M. ; OVER, H. ; CORSO, M. ; BRUGGER, T. ; BERNER, S. ; OSTERWALDER, J. ; GREBER, T.** Self-Assembly of a hexagonal boron nitride nanomesh on Ru(0001). *Langmuir,* 2007, vol. 23, 2928-2931
- **MORSCHER, M. ; OSTERWALDER, J. ; GREBER, T.** Formation of single layer h-BN on Pd(111). *Surf. Sci.,* 2006, vol. 600, 3280-3284
- **CUN, H. Y. ; LANNUZZI, M. ; HEMMI, A. ; ROTH, S. ; OSTERWALDER, J. ; GREBER, T.** Immobilizing individual atoms beneath a corrugated single layer of boron nitride. *Nano Lett.,* 2013, vol. 13, 2098-2103